# EUROPEAN PATENT SPECIFICATION

(11) **EP 0 473 069 B1**
(45) Date of publication and mention of the grant of the patent: **19.06.1996**
(21) Application number: 91114104.2
(22) Date of filing: 22.08.1991
(51) Int. Cl.: C23C 18/20

(54) **Electroless plating of materials having electrophilic polarity**
Stromlose Plattierung von Materialien mit elektrophiler Polarität
Dépôt chimique sur matériaux électrophiles

(30) Priority: 23.08.1990 JP 221930/90
(43) Date of publication of application: 04.03.1992
(73) Proprietor: Sankei Giken Kogyo Kabushiki Kaisha, Tokyo (JP)
(72) Inventor: Takagi, Kaneyuki, Tokyo (JP); Kita, Toshiyuku, Nara-shi, Nara-ken (JP); Sato, Kazuya, Katano-shi, Osaka-fu (JP); Yago, Masayuki, Omiya-shi, Saitama-ken (JP); Yoshikawa, Syuji, Urawa-shi, Saitama-ken (JP)
(74) Representative: Glawe, Delfs, Moll & Partner

(56) References cited:
- EP-A- 0 460 226
- DE-A- 2 526 026
- DE-A- 3 743 744
- GB-A- 901 252
- US-A- 4 017 265

## Description

This invention relates to an electroless plating of materials having electrophilic polarity, and, more particularly, it is concerned with a novel electroless plating method which is capable of preventing the electromagnetic interference, and which requires no surface-roughening step of the materials to be used for prodution of the printed circuit-wiring board.

The electroless plating is effected as a step for rendering a non-electrically conductive body such as shaped article of synthetic resin to become electrically conductive so that it may be subjected to the electrolytic plating, wherein the surface of the non-electrically conductive product to be plated is subjected to a pre-treatment for corroding it by any method to form very fine holes due to corrosion, and, in the electroless plating to be carried out subsequently, the plated layer is bonded to the suface of the base material by the anchoring effect of the metal to be deposited in the inner surface of the holes from the corrosion.

In the conventional technique for intercepting the electromagnetic wave, there are various methods such as application of electrically conductive paint, zinc spraying, laminating layers of electrically conductive synthetic resin compounded with an electrically conductive substance, or forming a sandwich structure with this electrically conductive synthetic resin as a core, and so forth. Of these various methods, the application of the electrically conductive paint has been widely diffused. Any of these methods, however, cannot be said to have exhibited satisfactory effect. Even the most widely used electrically conductive paint is very expensive in price, and, in addition, the paint coating is required to be made thick, which would increase the cost for the painting work. In recent years, the electromagnetic wave intercepting effect of the coating formed by the electroless plating has become highly evaluated, but it has still not attained its dissemination owing to its point of problem to be mentioned hereinbelow.

Also, for the manufacture of the conventional printed circuit-wiring board, there have been adopted various production steps of attaching by adhesion an electrolytic copper foil on the laminated sheet of thermosetting resin such as epoxy resin, phenolic resin, and so on, reinforced with glass fibers, or attaching by adhesion the electrolytic copper foil on a film of heat-resistant synthetic resin such as polyester resin, polyimide resin, and so forth, wherein only those required circuit wirings are retained, and the remaining unnecessary portions are dissolved (this being generally called "etching").

This method of manufacture, however, is not capable of producing the printed circuit-wiring board of a three-dimensional structure owing to the base plate being flat. In order therefore to manufacture such cubic wiring board, attempts have been made to simplify the manufacturing step of hole-punching, etc. in the circuit-wiring board by the injection-molding of the wiring board with use of a heat-resistant engineering plastic material. On the other hand, as a method for forming the electrically conductive circuit, studies have been conducted as to the method for carrying out the abovementioned etching, after the entire surface of the wiring board is covered with the copper coating, by adopting the conventional method of plating on the synthetic resin.

Moreover, there have already been known various methods of producing the printed circuit-wiring boards, in which an adhesive agent for the electroless plating is used (e.g., Japanese laid-open patent applications No. 1-115979, No. 2-8281, and No. 2-8283). The adhesive agents used for the electroless plating in these known methods are of the composition having greater corroding effect than the base material, which requires corroding step after its application.

As mentioned in the preceding paragraphs, when the conventional electroless plating method is effected on the synthetic resin, it becomes necessary to use a resin of a grade which is exclusively suited for the plating, in accordance with the specific resins to be used, so as to obtain satisfactory adhesion properties between the plated layer and the material (synthetic resin).

Further, with a view to securing sufficient adhesive properties between the plated layer and the base material or the adhesive layer, they are corroded with sulfuric-chromic mixed acid solution. As a consequence, there remain various problems from the aspects of environmental pollution.

With a view to solving the abovementioned problem, the present inventors have conducted various studies and experiments by first taking into consideration the fixing of the plate-coating by hot-melt type adhesives, as the result of which they discovered and proposed a method, in which a hot-melt type adhesive layer of a composition containing therein a high molecular weight compound having a polar group is formed on the part to be plated of a synthetic resin product, thereafter the synthetic resin product is immediately subjected to the electroless plating, without going through the corroding step, to thereby deposit the plate-coating, and finally the entire product is subjected to heating to fix the plate-coating onto the resin product (vide: Japanese patent application No. 1-198207).

When the abovementioned method is applied to polypropylene, however, low chlorinated poplypropylene contained in the adhesive agent for polypropylene hinders deposition of the plate-coating. In order therefore to intercept this hindrance and to avoid decrease in the adhesive property of the coating, there was further proposed an adhesive composition which contains therein an additive having such preventive functions that does not lower the adhesive property of the plate-coating (vide: Japanese patent application No. 1-198208).

The present inventors further conducted studies and experiments, as the result of which they have discovered and proposed a novel method of plating (vide: Japanese patent application No, 1-334164 or its patent family member EP-A-0 460 226), which does not require inclusion of the polar group in the adhesive agent and heating operation after the electroless plating, as contrasted to the abovementioned prior invention, wherein the presence of the polar group in the adhesive composition was essential.

In the practice of the abovementioned proposed invention, experiment was done, by chance, on glass-fiber-reinforced polyester, in consideration of application of the abovementioned low clorinated polypropylene as a masking agent for a portion where no plating is required. It was found, contrary to their expectation, that a tightly adhered plate-coating could be formed. With a view to applying this finding to other purposes, further studies and experiments were conducted from various aspects such as whether this phenomenon is based on the chemical structure of polyester itself, or whether it is due to the glass fibers contained in the polyester as the filler, or whether both polyester and glass fiber are effective for this phenomenon, or why such tight adhesion of the plate-coating could be obtained. As the result, the present inventors found that polyacrylonitrile containing therein highly nucleophilic nitrile group also exhibits the same effect as the abovementioned polyester, and further detailed studies of their finding led to the completion of the present invention.

That is to say, the present invention is to carry out the electroless plating by applying, onto a surface to be plated having an electrophilic polarity, a solution of a polymer comprising polyacrylonitrile or low chlorinated polypropylene with a maximum chlorine content of 30% to form a thin film of the polymer thereon, followed by carrying art the electroless plating such that a heat-treatment is effected to increase adhesion of the thin film to a subsequent applied coating formed by electroless plating wherein said heat treatment is performed at 140-200°C when said polymer is polyacrylonitrile, and wherein said heat treatment is performed at 140-170°C when said polymer is low chlorinated polypropylene.

The electroless plating method according to the present invention is one which substitutes a step for forming a layer of a polymer having the nucleophilic substituent group on the carbon chain for the corroding step to be carried out in the conventional electroless plating method of a synthetic resin product.

The material to be plated, on which the method of the present invention is applied, is one having the electrophilic polarity. The materials having the electrophilic polarity are designated by those resin materials having the electrophilic bond structures, the terminal structures, or the substituent groups in their molecular structures. The matrix resins may be those added with inorganic filler, even if they are non-polar, or those resins, with which the electrophilic resin is blended. Besides these, there may be used metals, ceramics, wood, cotton, silk, and other natural materials.

The plated layer resulting from the sequential steps of defattening , catalyst attaching, reaction accelerating, and immersion into the electroless plating liquid in accordance with the conventional method, after a thin layer is formed on the surface to be plated of the article constituted with such material by use of a solution of a polymer having the nucleophilic substituent group on the carbon chain.

The electrophilic resin materials, to which the method of the present invention is applicable, i.e., the resins having the electrophilic bond structure, are those resins containing therein the amide bonding, the imide bonding, the ester bonding, the carbonyl bonding, and so forth. Examples of such resins are: Nylon, polyimide resin, polybutyrene terephthalate resin (hereinafter abbreviated as "PBT"), polycarbonate resin (hereinafter abbreviated as "PC"), polyether-ether-ketone (hereinafter abbreviated as "PEEK"), and so forth.

Also, the resins having the electrophilic substituent group are those containing therein the amino group, glycidyl group, etc., examples of which are epoxy resin, melamine resin, and so on.

Further, the resins compounded with inorganic fillers are those which are compounded with talc, mica, aluminium hydroxide, glass fibers, etc., or oxides or hydroxides of magnesium, aluminum, silicon, etc., or neutral salts such as calcium carbonate, barium sulfate, etc.. Furthermore, the resins blended with electrophilic resin are designated, for example, by polymer alloys of Nylon and polypropylene, or Nylon and polyphenyleneoxide (hereinafter abbreviated as "PPO").

Besides the abovementioned various resin materials, the method of the present invention may also be applicable to metals, ceramics, wood, cotton, silk and other natural materials.

For the purpose of the electroless plating according to the method of the present invention, the polymers having the nucleophilic substituent group on the carbon chain, to be an intermediary layer for adhesion between the surface to be plated and the plate-coating, are designated by low halogenated polypropylene and polyacrylonitrile. Polyacrylonitrile may be a copolymer.

The most generally used low chlorinated polypropylene, out of those halogenated polypropylenes, has a chlorine content of 30% or less, or more preferably, in a range of from 20 to 25%. When the chlorine content exceeds 30%, the adhesion of the coated layer becomes insufficient. A considerably higher content of chlorine would hinder the deposition of the plated layer.

For the formation of the thin layer of low chlorinated polypropylene, the surface to be plated is coated with its 0.5 to 5% solution of an aromatic hydrocarbon solvent or chlorinated hydrocarbon solvent, followed by drying the coating. Depending on the material to be plated, appropriate selection of the solvent may become necessary.

For the formation of the thin layer of polyacrylonitrile, the polymer is first dissolved into a solvent of strong polarity such as DMF, DMI, N-methyl pyrrolidone, etc., and then the solution is applied onto the surface to be plated. Of these solvents, use of DMF having a low boiling point is preferable. Polyacrylonitrile can only be dissolved into the abovementioned solvents of strong polarity. Therefore, when it is to be coated on the material with low polarity to be plated, it is repelled on the surface of the material to be plated, hence cannot be coated thereon, or, even if it can be coated, the coating has low adhesiveness with the base material. Applicable materials are therefore limited to those having strong electrophilic property (e.g., polyimide, epoxy resin, etc.).

For the coating of the resin material, there may be adopted a spraying method by means of a spray gun, a coating method by means of a coater or a dispenser, a pull-up method after immersion in a soution, and others. Any of these methods can be arbitrarily selected depending on the purpose of plating, location where the plating is to be effected, and configuration of the product to be plated.

When forming the thin film by applying the polymer solution, it is preferable to effect heat-treatment of the base material to be plated for two times before and after the application of the coating solution, or either before or after the coating. This heat-treatment contributes to increase in the peeling strength of the plate-coating.

The heat-treatment to be effected before the abovementioned application of the solution is the pre-heating of the surface to be plated to a temperature below the boiling point of the solvent to be used. Also, the heat-treatment after the application of the coating is the heating of the material to be plated for a short period of time at a temperature which is close to a melting point of the thin film resin, within such an extent that the material to be plated does not bring about thermal deformation after this thin film formation. For instance, in the case of the low chlorinated polypropylene, the heating temperature may be in a range of from 140°C to 170 °C, or, in the case of polyacrylonitrile, the temperature range is at 140-200 °C, although, in the latter case, the heating should preferably be done in a nitrogen current.

The reason for the plated coating being tightly adhered to the thin film layer of the abovementioned low chlorinated polypropylene can be assumed as follows.

When the method of the present invention is applied to the polypropylene not compounded with a filler, there takes place hindrance to adhesion of the plate-coating on the surface of a material to be plated; with the polypropylene compounded with talc, however, there can be obtained the plated layer tightly adhered onto the material to be plated, and moreover, the adhesive strength increases with the heat-treatment, whereby the chlorine radical in the chlorinated polypropylene having high electronegativity is orientated to the side of the base material layer containing therein the electrophilic filler, the front surface side of which has no chlorine radical, but the hydrogen atom of low electron desnity, and state of the electron density distribution on the thus formed surface part is considered to be preferable for the deposition and adherance of the plated layer.

The heat-treatment to be effected before and after the application of the solution is to facilitate orientation of the nucleophilic substituent group toward the side of the electrophilic base material. With increase in the orientation, the adhesiveness of the plate-coating rises.

In the following, preferred examples of the present invention will be shown in respect of materials to be used and the conditions to be applied. The manner of putting the method into practice and the method of testing the results of the electroless plating, in these examples, are as follows.

### 1. Preparation of Test Specimens:

Injection-molded test pieces of a thermoplastic resin and press-shaped test pieces of thermosetting resin, each having thickness of 2 to 3 mm, as well as films having thickness from 50 to 100 µm were each cut into a size of 40 x 70 mm, and the surface of each piece was coated, by means of a poster-drawing brush, with a toluene solution or a chlorocyclohexane solution of a predetermined concentration of low chlorinated polypropylene ^{(*)} (hereinafter abbreviated as "low chlorinated PP"), and a DMF solution of polyacrylonitrile^{(**)} of a predetermined concentration (hereinafter abbreviated as "PAN"), as the coating solution.

After this, the coating was dried at an ordinary temperature. Subsequent to the drying, each test piece was subjected to heat-treatment under predetermined conditions, in utilization of a high temperature side of a thermal shock tester, thereby preparing the test specimens.

[NOTE]
- (*) -: products of Sanyo Kokusaku Pulp K.K., Japan under tradenames of "SUPER CURON 822" (with the chlorine content of 24.5%) and "SUPER CURON 803MW" (with the chlorine content of 29.5%)
- (**) -: a product of Mitsui-Toatsu Chemical Co. Ltd., Japan under a tradename of "BAREX 1000S"

### 2. Electroless Plating:

With use of chemical liquids and under the plating conditions, as mentioned hereinbelow, the electroless plating was conducted in accordance with the conventional method.

Chemical Liquid Used:
- Defattening agent:: "ACE CLEAN A 220", a product of Okuno Seiyaku Kogyo K.K., Japan
- Catalyst liquid:: "CATALYST C", a product of Okuno Seiyaku Kogyo K.K.,Japan
- Reaction Accelerator:: hydrochloric acid (10% conc.)
- Electroless copper plating liquid:: "TSP 810", a product of Okuno Seiyaku Kogyo K.K., Japan
- Electroless nickel plating liquid:: "TMP Chemical Nickel", a product of Okuno Seiyaku Kogyo K.K., Japan

Plating Conditions: defattening at 50°C for 5 mins.; rinsing; immersion into catalyst liquid at an ordinary temperature for 5 mins.; immersion into reaction accelerator liquid at an ordinary temperature for 5 mins.; rinsing; immersion into warm water bath at 50°C for 1 min.; immersion into electroless plating liquid at 50°C for 5 mins.; washing; drying

### 3. Evaluation:

The evaluation of the test results of the electroless plating was done on three items, as follows: i) conditions of deposition, inclusive of deposition rate of the plate coating and presence or absence of blisters; ii) peeling strength of the plate-coating layer in its condition as it is deposited right after the plating, or in its condition after lapse of 24 hours, by means of cellophane tape (provided that the condition after 24 hours' lapse was evaluated by the cross-cut adhesion test); and iii) thermal shock test by repeating, for ten cycles, the thermal stresses of heating the test specimens at 80 °C for 1 hr., maintaining it at ordinary temperature for 20 mins., and refrigerating it to -30°C for 1 hr.

The results of evaluation are indicated by symbols of "○"," △", and "×", each of which has the following meaning.

| Item for Evaluation | Symbol for Evaluation | Meaning of Symbol |
|---|---|---|
| ① conditions of deposition of plate coating | × | adhesion of the plate-coating being 50% or below |
| | Δ | adhesion of the plate-coating being 50 to 99% |
| | ○ | perfect adhesion of the plate-coating (100%) |
| ② peeling strength | × | readily peeled with cellophane tape in its state as it is |
| | Δ | peeled at the time of cross-cut adhesion test |
| | ○ | perfect cross-cut adhesion test (100/100) |
| ③ thermal shock test | × | cracked |
| | Δ | creased |
| | ○ | no change |

### Examples 1 to 6; and Comparative Examples 1 and 2

Injection-molded test pieces were made from the following eight kinds of materials: glass fiber-reinforced PBT, non-reinforced PBT, non-reinforced Nylon 66, PP compounded with 20% of talc, PP compounded with 20% of BaSO₄, PP mixed with Nylon 6, these being for the purpose of the Examples according to the present invention; and fillerless PP, and PAN having the nucleophilic substituent group. Onto two sheets each of these injection-molded test pieces, there was applied 1% solution of a low chlorinated PP with the chlorine content of 24.5% with toluene and cyclohexane as the solovents, the one having been left as it was, while the other having been subjected to the heat-treatment for 5 mins. at a temperature of 140 °C , and then each of these test pieces was subjected to the electroless copper plating. The results are as shown in Table 1 below.

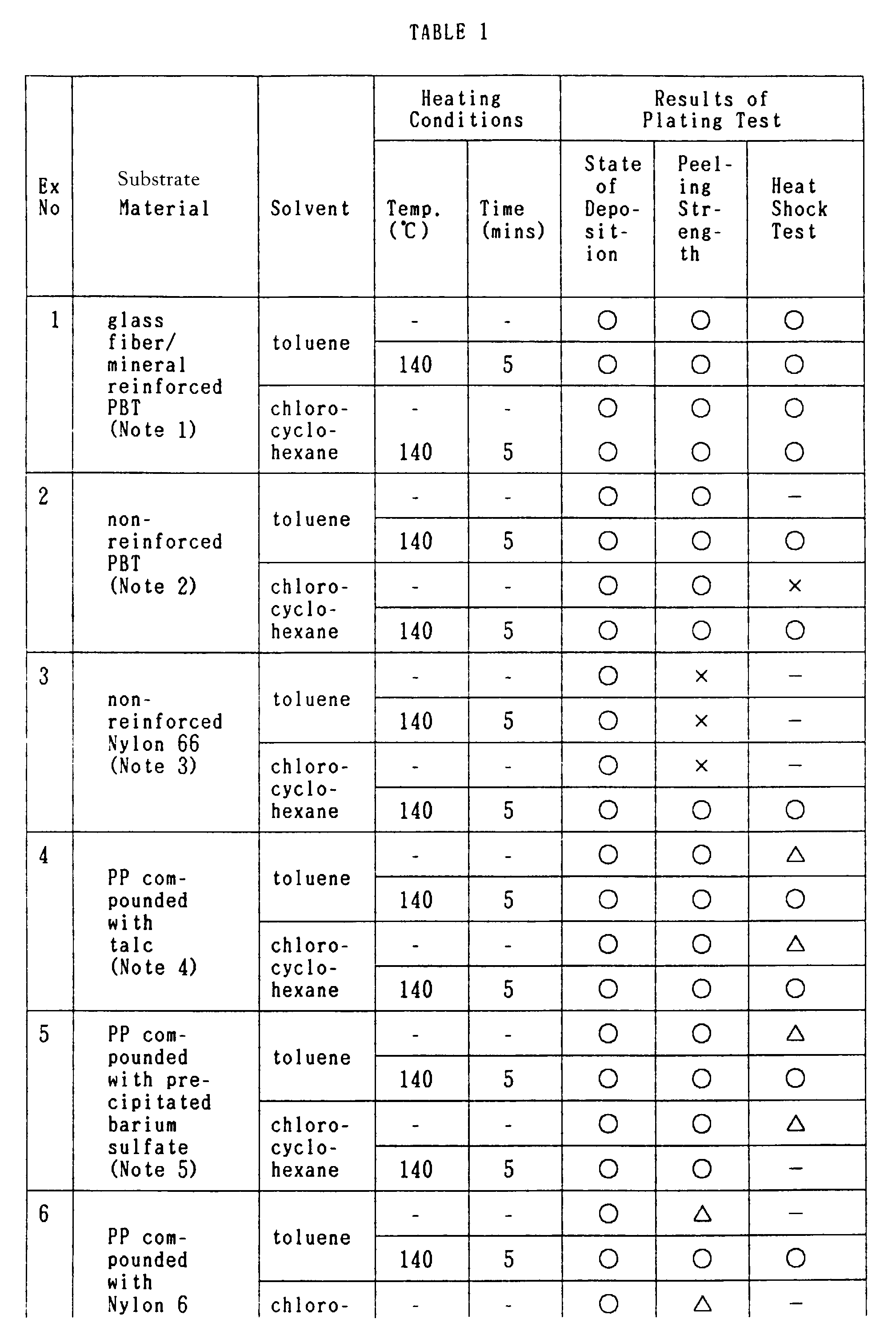

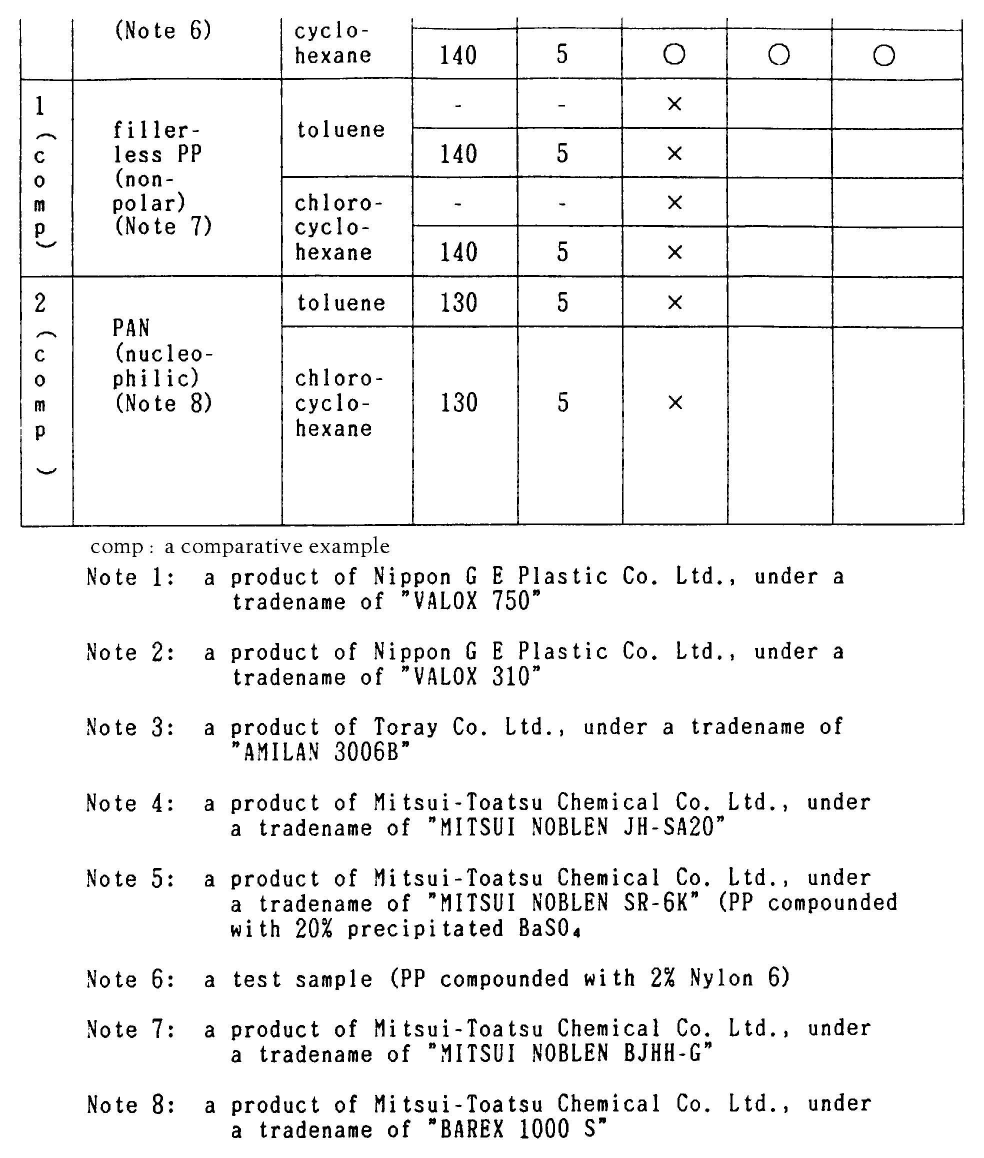

### Examples 7 to 9

Test pieces were prepared by use of low chlorinated PP with the chlorine contents of 24.5% and 29.5% for each of the injection-molded pieces of Nylon 66, a polymer alloy of Nylon 66/PPO, and PBT, with varied solvents and solvent concentration and under different specimen preparation conditions. The results of the electroless copper plating on these test specimens are as shown in Table 2 below.

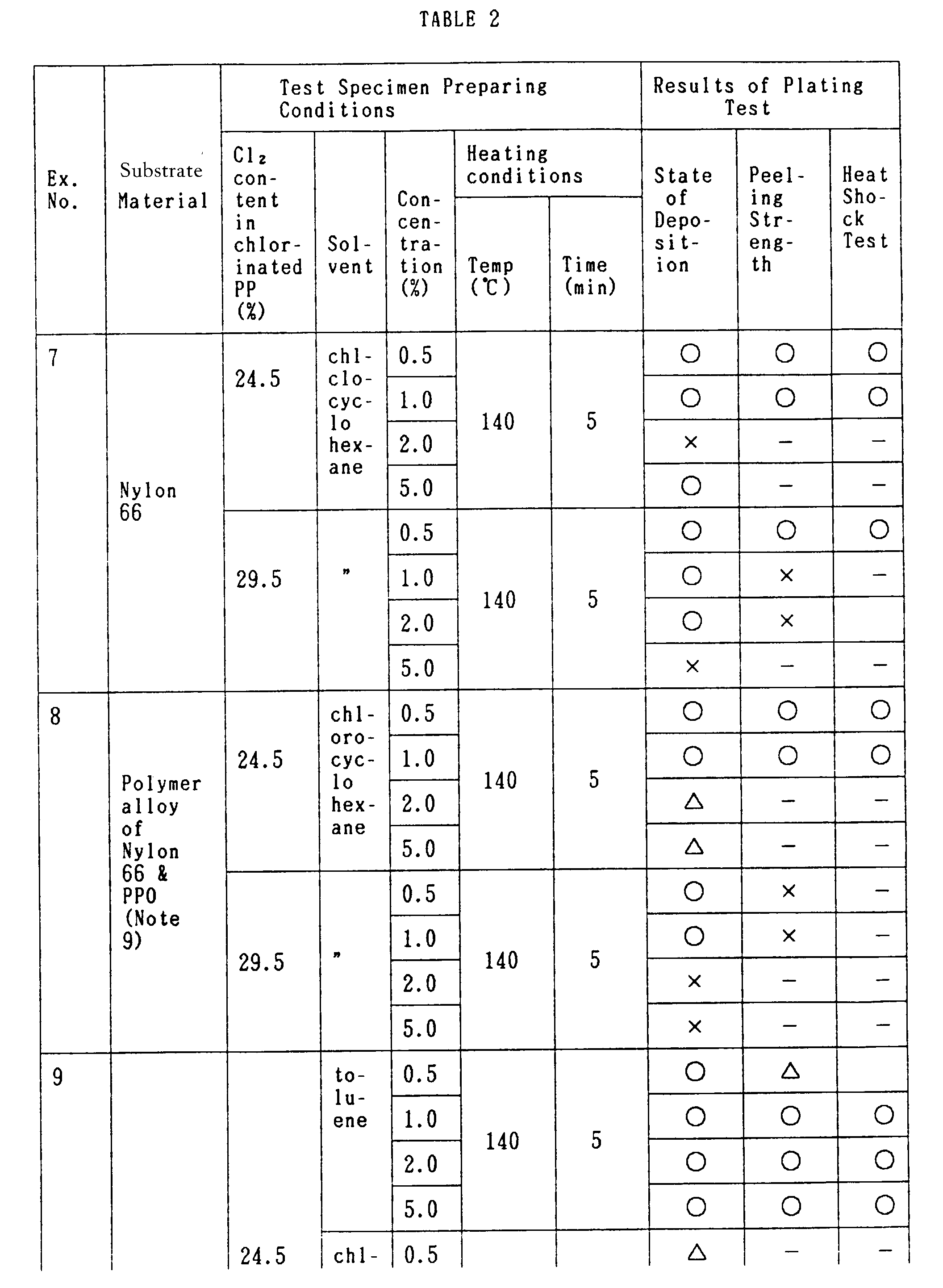

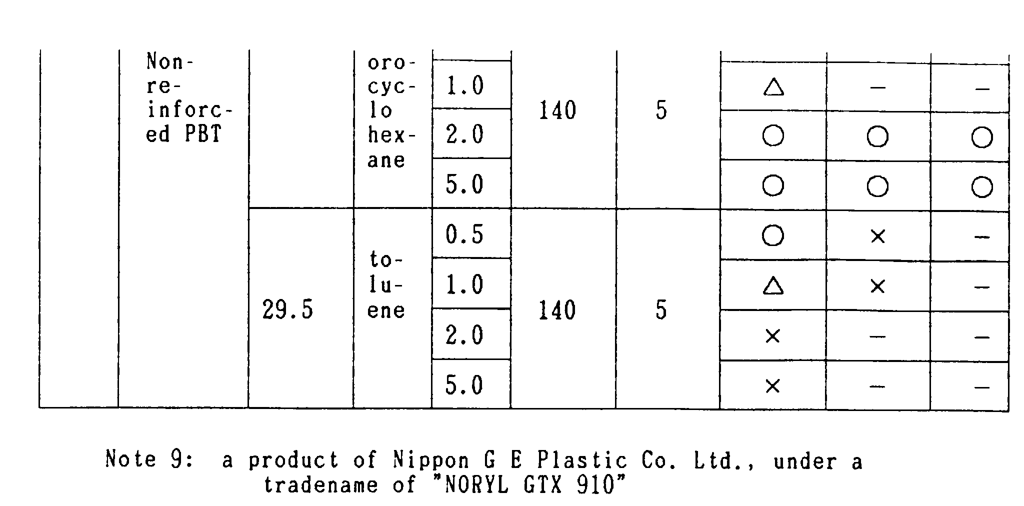

### Examples 10 to 26

Test pieces were prepared under the conditions as shown in Table 3 below, with use of low chlorinated PP with the chlorine content of 24.5%, which was compounded with the below-listed eight kinds of thermoplastic resins and five kinds of thermosetting resins, a non-sysnthetic resin plate of "SUS 430", an alumina-ceramic plate, a wooden piece of *hinoki* (Japanese cypress), and cotton cloth, as the test materials. The results of the electroless copper plating on these specimens are as shown in Table 3 below.

### [8 kinds of thermoplastic resins used]

PC; polymer alloy of PC & PBT; PEEK; modified maleimide resin; polyetherimide; thermoplastic PI; two kinds of crystal resins

### [5 kinds of thermosetting resins used]

glass-fiber reinforced unsaturated polyester resin; phenolic resin-impregnated glass cloth; epoxy resin-impregnated paper melamine resin; melamine resin; urea resin

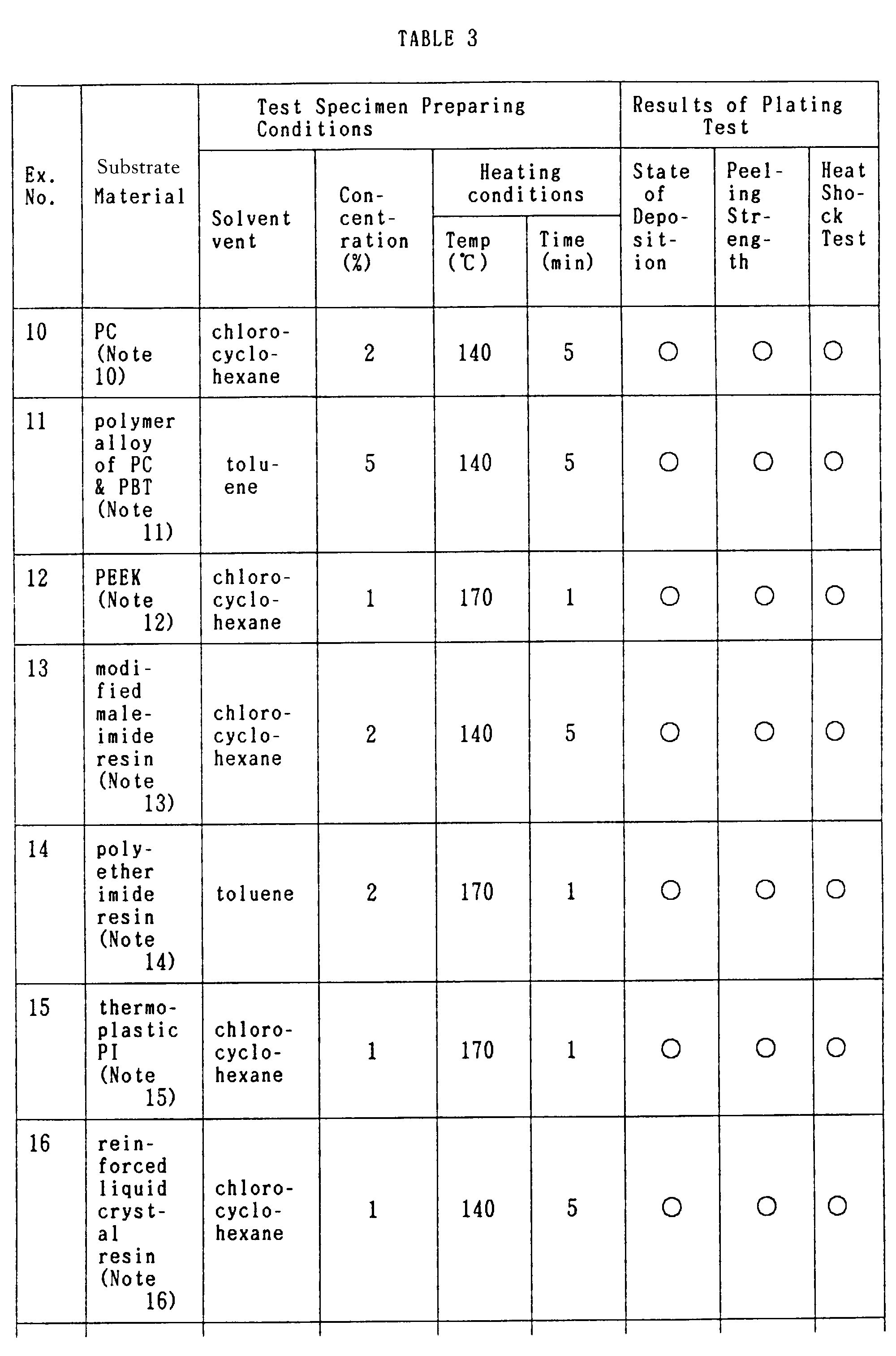

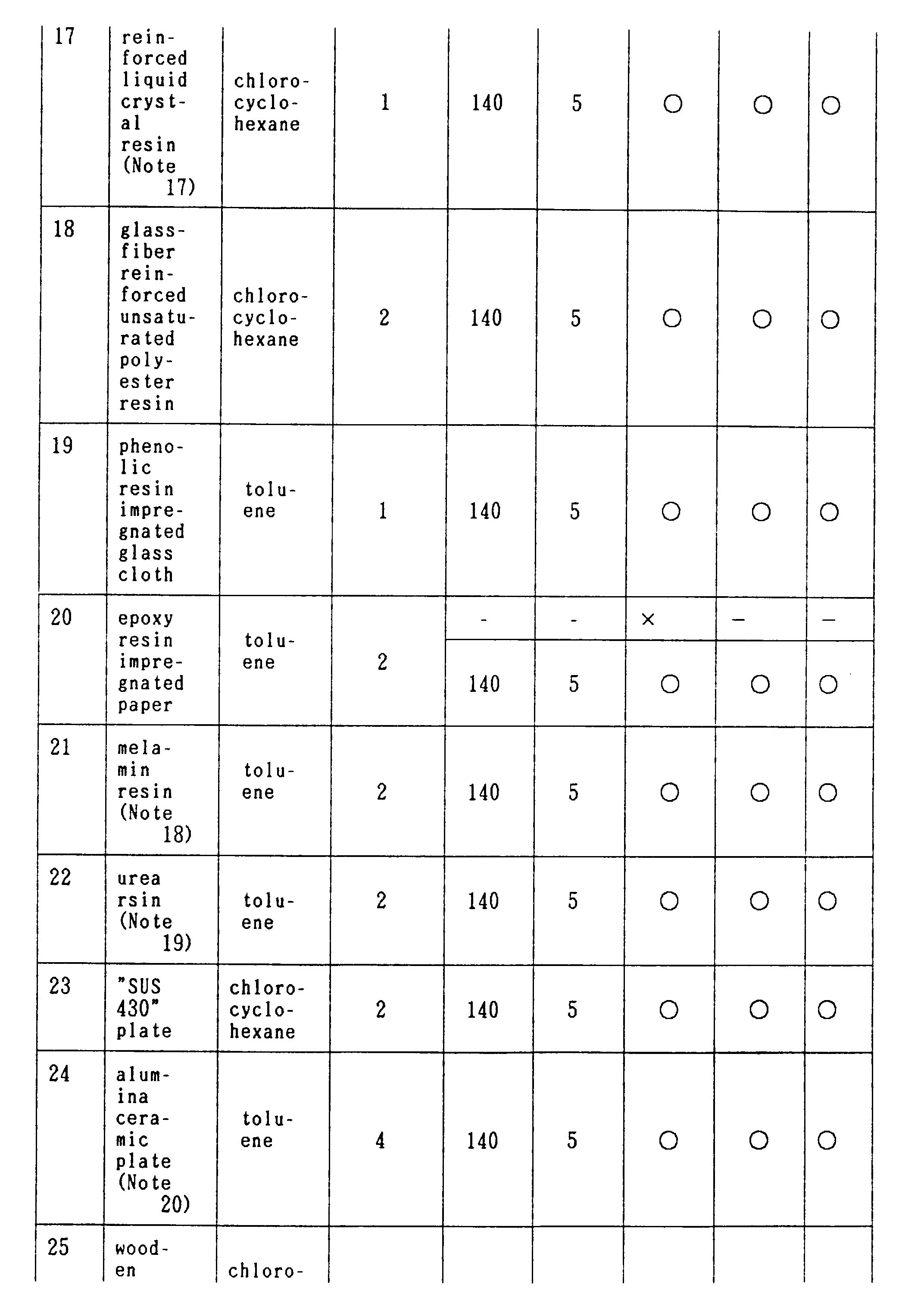

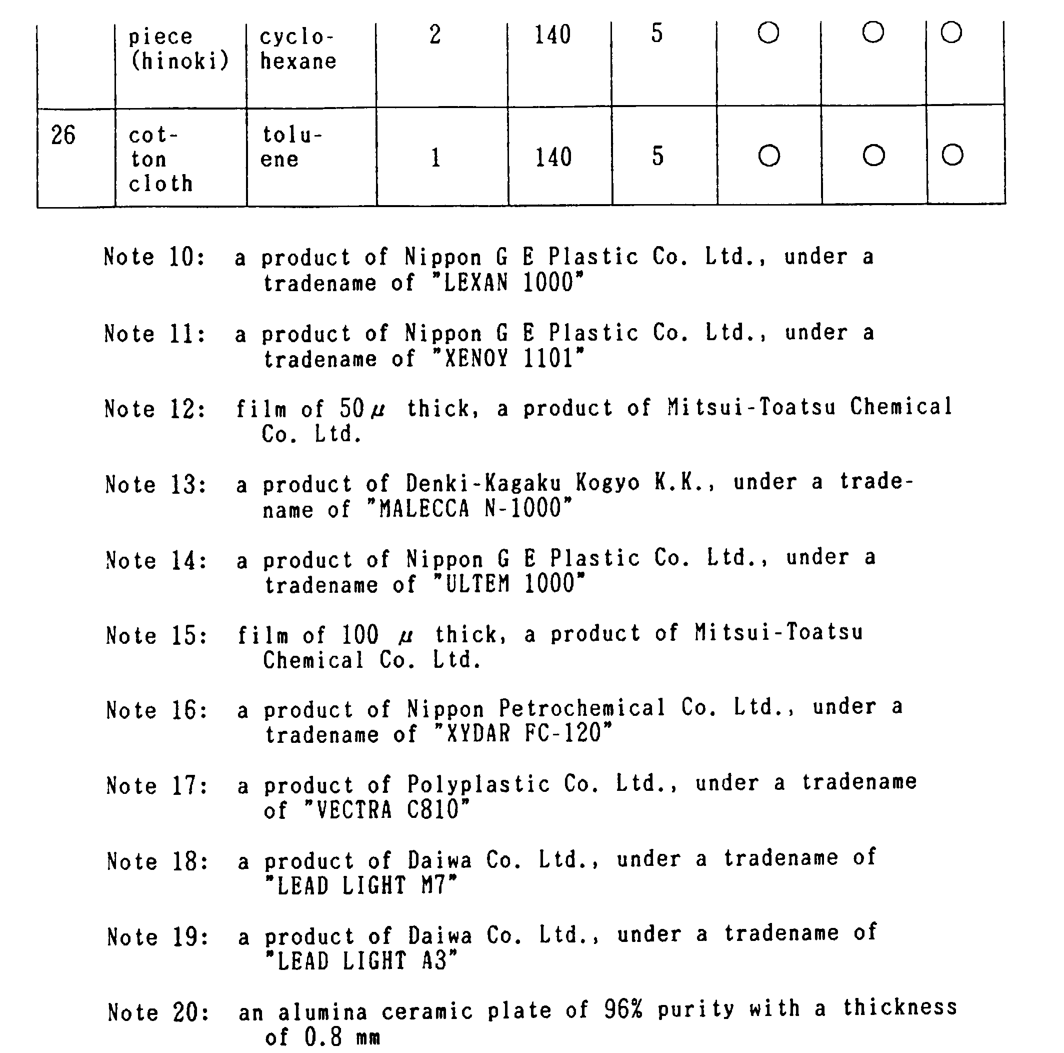

### Examples 27 and 28

Test pieces were prepared under the conditions as shown in Table 4 below using a DMF solution of PAN which was coated on the thermoplastic polyimide resin film and epoxy resin-impregnated paper. The results of the electroless copper plating are as shown in Table 4.

**TABLE 4**

| Ex. No. | Substrate Material | Concentration (%) | Heating Conditions | | Results of Plating Test | | |
|---|---|---|---|---|---|---|---|
| | | | Temp (°C) | Time (min) | State of Deposition | Peeling Strength | Heat Shock Test |
| 27 | thermoplastic polyimide resin | 1 | - | - | ○ | ○ | ○ |
| | | 1 | 140 | 5 | ○ | ○ | ○ |
| | | 1 | 170 | 1 | ○ | ○ | ○ |
| | | 0.5 | 140 | 5 | ○ | Δ | |
| | | 2.0 | | | ○ | ○ | ○ |
| | | 5.0 | | | ○ | ○ | ○ |
| 28 | epoxy resin impregnated paper | 1 | 140 | 5 | ○ | ○ | ○ |
| | | 2 | | | ○ | ○ | ○ |
| | | 5 | | | ○ | ○ | ○ |

### Examples 29 to 31

Using injection-molded test pieces of carbon fiber-reinforced thermoplastic polyimide resin, there were prepared test specimens, on each of which a thin film of DMF solution of polyacrylonitrile formed under different heat-treatment conditions were coated. The test specimens were then subjected to the electroless copper plating for a period of 20 minutes. The test pieces as copper-plated were further subjected to the electrolytic plating of copper to a film thickness of about 50 µm, followed by the 90-degree peeling test. The results are shown in Table 5 below.

**TABLE 5**

| Ex. No. | Substrate Material | Concentration (%) | Heat-Treatment Conditions | | | | Test Result |
|---|---|---|---|---|---|---|---|
| | | | Pre-Heating | | After Coating | | 90-degree Peeling Strength (kg/cm) |
| | | | Temp °C | Time (min) | Temp °C | Time (min) | |
| 29 | Carbon fiber reinforced polyimide resin | 4 | | | 170 | 1 | 0.5 ∼ 0.9 |
| 30 | | | 150 | 5 | | | 1.0 ∼ 1.3 |
| 31 | | | 150 | 5 | 170 | 1 | 1.2 ∼ 1.4 |

### Examples 32 and 33

PP compounded with talc and epoxy resin impregnated paper were used as the test material to prepare the test pieces under the conditions as indicated in Table 6 below, with the low chlorinated PP as the intermediary adhesive layer for the former, and PAN for the latter. Then, the thus prepared test pieces were subjected to the electroless nickel plating. The results are shown in Table 6.

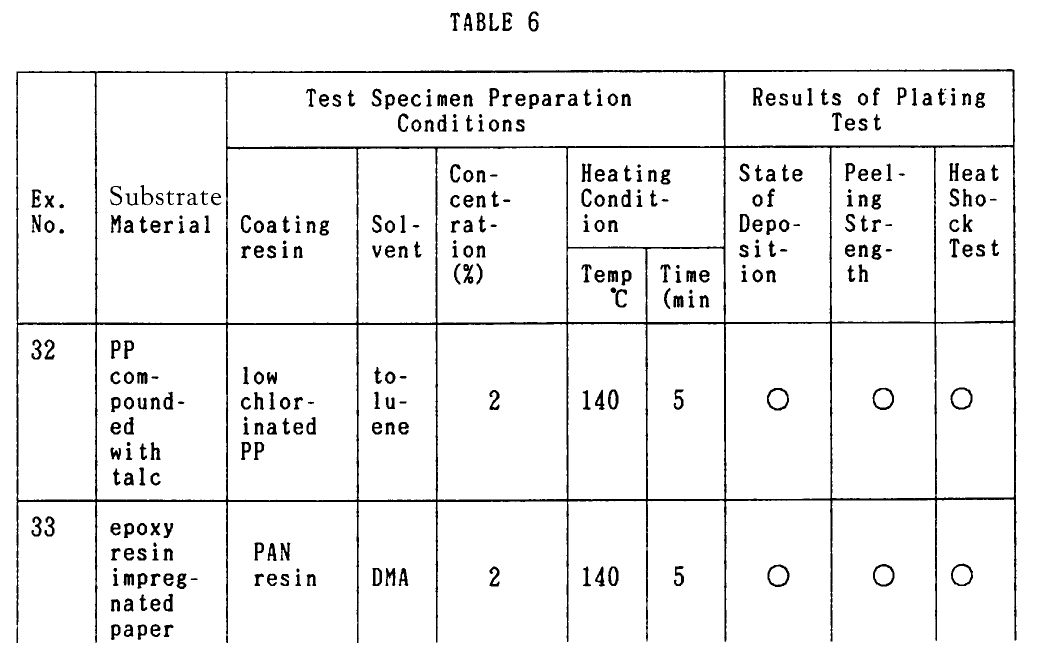

As mentioned in the foregoing, since the method of the present invention does not require the corrosion treatment of the surface to be plated, the electroless plating can be done easily at any place; also, since the method does not require the surface of the materials (e.g., thermosetting resins such as BMC or SMC of unsaturated polyester, melamine resin, phenolic resin, epoxy resin, etc., or PEEK, polyimide resin, etc. which is called "super-engineering plastics" in the industry concerned), which are difficult to be roughened by the corrosion treatment, to be modified in advance so that it becomes corrosive, the electroless plating can be done very easily. Further, the carbon-fiber-reinforced plastic which has so far been considered impossible to be subjected to the electroless plating by the conventional corroding method can be plated easily by the method of the present invention.

Accordingly, not only the thus electroless plated article can be used for the electromagnetic wave shielding, but also the plate-coating to be obtained by the electroless plating on the polyacrylonitrile coating formed on the surface of the polyimide resin shaped article can sufficiently withstand the soldering temperature, with the consequence that it becomes possible to readily manufacture the cubic printed circuit wiring board, flexible printed circuit wiring board, etc., the industrial merit of which is very great.

## Claims

1. An electroless plating method comprising applying, on a surface to be plated having an electrophilic polarity, a solution of a polymer comprising polyacrylonitrile or a chlorinated polypropylene having a maximum chlorine content of 30% to form a thin film of the polymer thereon, followed by carrying out the electroless plating, **characterized** in that a heat-treatment is effected to increase adhesion of the thin film to a subsequently applied coating formed by electroless plating, wherein said heat treatment is performed at 140°C-200°C when said polymer is polyacrylonitrile, and wherein said heat treatment is performed at 140°C-170°C when said polymer is low chlorinated polypropylene.

## Patentansprüche

1. Stromloses Plattierungsverfahren mit dem Aufbringen, auf eine zu plattierenden Oberfläche mit elektrophiler Polarität, einer Lösung aus einem Polymer, das Polyacrylonitril oder ein chloriniertes Polypropylen mit einem Maximalchlorinhalt von 30 % aufweist, zur Ausbildung eines dünnen Filmes auf dem Polymer, gefolgt von der Durchführung des stromlosen Plattierens, dadurch **gekennzeichnet**, daß eine Wärmebehandlung durchgeführt wird, um die Adhäsion des dünnen Films an einer später angebrachten Beschichtung, die durch stromloses Plattieren gebildet wird, zu erhöhen, wobei die Wärmebehandlung bei 140°C bis 200°C durchgeführt wird, wenn das Polymer Polyacrylonitril ist, und wobei die Wärmebehandlung bei 140°C bis 170°C durchgeführt wird, wenn das Polymer niederchloriertes Polypropylen ist.

## Revendications

1. Méthode pour dépôt chimique sans courant comprenant l'application, sur une surface qui doit être plaquée ayant une polarité électrophile, d'une solution d'un polymère comprenant le polyacrylonitrile ou un polypropylène chloré ayant une teneur maximale en chlore de 30 % afin de former une couche mince dudit polymère sur ce-dernier, suivi par l'accomplissement dudit dépôt chimique sans courant, **caractérisé** en ce qu'un traitement thermique est effectué afin d'augmenter l'adhésion de ladite couche mince à un revêtement appliqué ultérieurement formé par dépôt chimique sans courant, ledit traitement thermique s'accomplissant à 140°C-200°C lorsque ledit polymère est le polyacrylonitrile, et ledit traitement thermique s'accomplissant à 140°C-170°C lorsque ledit polymère est le polypropylène à basse teneur en chlore.
